# FASCICULE DE BREVET EUROPEEN

(11) **EP 0 757 797 B1**
(45) Date de publication et mention de la délivrance du brevet: **02.09.1998**
(21) Numéro de dépôt: 95917408.7
(22) Date de dépôt: 14.04.1995
(51) Int. Cl.: G01R 29/033, H02G 13/00, G01W 1/16

(54) **PROCEDE ET DISPOSITIF DE SURVEILLANCE D'UN EQUIPEMENT DE PROTECTION CONTRE LA FOUDRE**
VERFAHREN UND VORRICHTUNG ZUR ÜBERWACHUNG EINER BLITZSCHUTZANLAGE
METHOD FOR MONITORING LIGHTNING PROTECTION EQUIPMENT

(30) Priorité: 18.04.1994 FR 9404597
(43) Date de publication de la demande: 12.02.1997
(73) Titulaire: Lewiner, Jacques, 92210 Saint-Cloud (FR); Smycz, Eugeniusz, F-91240 Saint-Michel-Sur-Orge (FR)
(72) Inventeur: Lewiner, Jacques, 92210 Saint-Cloud (FR); Smycz, Eugeniusz, F-91240 Saint-Michel-Sur-Orge (FR)
(74) Mandataire: Burbaud, Eric
(86) Numéro de dépôt international: FR9500499
(87) Numéro de publication internationale: WO9528646

(56) Documents cités:
- EP-A- 0 023 708
- US-A- 3 889 185
- US-A- 4 112 357
- PATENT ABSTRACTS OF JAPAN vol. 17 no. 310 (E-1380) ,14 Juin 1993 & JP,A,05 029060 (MITSUBISHI ELECTRIC CORP)

## Description

La présente invention est relative aux procédés et dispositifs de surveillance des équipements de protection contre la foudre, notamment paratonnerres, et éclateurs ou parafoudres.

Les paratonnerres comportent une pointe ou une tige métallique dressée verticalement sur le faîte d'un édifice à protéger et reliée au sol par une ligne de mise à la terre. Du fait qu'elle est au potentiel de la terre, la pointe métallique capte la foudre, et la ligne de mise à la terre conduit la foudre jusqu'au sol, où celle-ci se dissipe.

L'énergie de la foudre captée par un paratonnerre pouvant être considérable, cette énergie peut éventuellement endommager la ligne de mise à la terre, ou plus couramment dessécher le sol à l'interface entre ce sol et la ligne de mise à la terre. Lorsque cela se produit, il en résulte une résistance plus élevée que la normale entre la pointe du paratonnerre et la terre.

Par conséquent, la ligne de mise à la terre qui court sur la hauteur de l'édifice à protéger est alors portée à des potentiels électriques très élevés lorsque la foudre tombe sur le paratonnerre. Ces potentiels peuvent à leur tour se propager dans la structure du bâtiment en risquant d'engendrer des incendies, ou au moins de perturber gravement le fonctionnement des appareils électriques ou électroniques contenus dans l'édifice à protéger.

Pour éviter de tels accidents, on contrôle donc de temps à autre la qualité de liaison électrique entre le paratonnerre et la terre.

Ce contrôle peut être effectué à intervalles de temps réguliers, mais il risque alors d'être inutile si la foudre n'est pas tombée sur le paratonnerre depuis le contrôle précédent, ou d'être trop tardif si la foudre a endommagé le paratonnerre peu de temps après le dernier contrôle.

C'est pourquoi on surveille parfois le paratonnerre en comptant le nombre de fois où la foudre est tombée sur ce paratonnerre depuis le contrôle précédent. Lorsque ce nombre atteint une valeur prédéterminée, on contrôle la qualité de la liaison électrique entre le paratonnerre et la terre.

Habituellement, ce comptage est effectué au moyen d'un dispositif comportant un circuit magnétique qui est fermé sur lui-même autour de la ligne de mise à la terre du paratonnerre, et un circuit électrique comportant au moins une spire enroulée autour du circuit magnétique de façon qu'un courant de foudre parcourant la ligne de mise à la terre engendre dans cette spire un courant induit, la spire étant connectée à un relais dont chaque fermeture incrémente d'une unité un compteur mécanique.

Toutefois, ce mode de surveillance d'un paratonnerre présente l'inconvénient de ne pas prendre en compte l'importance des coups de foudre reçus par le paratonnerre.

En effet, un nombre prédéterminé de coups de foudre de faible énergie ne produira aucun dégât sur la ligne de mise à la terre, et produira relativement peu de dessèchement du sol à l'interface entre ce sol et la ligne de mise à la terre, tandis qu'un seul coup de foudre ayant une énergie exceptionnelle risque à lui seul, soit de détruire ou d'endommager la ligne de mise à la terre, soit de dessécher considérablement le sol à l'interface entre ce sol et la ligne de mise à la terre.

Les mêmes inconvénients s'appliquent aux procédés de surveillance des autres équipements de protection contre la foudre, notamment éclateurs ou parafoudres, par simple comptage des coups de foudre. En effet, dans le cas des éclateurs ou parafoudres, un coup de foudre de forte énergie risque d'endommager non seulement la liaison avec la terre, mais aussi et surtout l'éclateur ou parafoudre lui-même.

Par ailleurs, le document US-A-4 112 357 décrit un procédé de surveillance d'un équipement de protection contre la foudre présentant une ligne de mise à la terre qui est destinée à dissiper des coups de foudre et qui est parcourue alors par un courant électrique, dit courant de foudre, ce courant de foudre présentant une certaine intensité et un certain spectre en fréquence, procédé dans lequel on effectue une mesure de l'intensité du courant de foudre, cette mesure étant une fonction sensiblement linéaire du courant de foudre.

Mais ce procédé ne permet que de mesurer l'intensité électrique du courant de foudre maximum qui a été dissipé par la ligne de mise à la terre pendant une période de temps donnée, ce qui est insuffisant pour surveiller convenablement un équipement de protection contre la foudre.

De plus, la mesure obtenue par ce procédé peut être sensible au spectre en fréquence du courant de foudre mesuré.

La présente invention a donc notamment pour but de proposer un procédé de surveillance d'un équipement de protection contre la foudre présentant une ligne de mise à la terre qui est destinée à dissiper les coups de foudre et qui est parcourue alors par un courant électrique, dit courant de foudre, ce courant de foudre présentant une certaine intensité et un certain spectre en fréquence, procédé dans lequel on effectue une mesure de l'intensité du courant de foudre, cette mesure étant une fonction sensiblement linéaire du courant de foudre, et on effectue cette mesure à chaque fois que la ligne de mise à la terre dissipe un coup de foudre.

A cet effet, selon l'invention, un procédé de surveillance du genre en question est caractérisé en ce qu'on effectue cette mesure à chaque fois que la ligne de mise à la terre dissipe un coup de foudre, et en ce qu'on enregistre au moins une valeur du courant de foudre et une date de ce courant de foudre à chaque fois que la ligne de mise à la terre dissipe un coup de foudre.

L'invention a également pour objet un dispositif de de surveillance d'un équipement de protection contre la foudre comportant une ligne de mise à la terre qui est destinée à dissiper des coups de foudre et qui est parcourue alors par un courant électrique, dit courant de foudre, ce courant de foudre présentant une certaine intensité et un certain spectre en fréquence, le dispositif comportant des moyens de mesure pour effectuer une mesure de l'intensité du courant de foudre, cette mesure étant une fonction sensiblement linéaire du courant de foudre, caractérisé en ce que les moyens de mesure sont adaptés pour mesurer l'intensité du courant de foudre à chaque fois que la ligne de mise à la terre dissipe un coup de foudre, et en ce que des moyens d'enregistrement sont prévus pour enregistrer au moins une valeur du courant de foudre et une date de ce courant de foudre à chaque fois que la ligne de mise à la terre dissipe un coup de foudre.

Dans des modes de réalisation préférés du dispositif selon l'invention, on a recours en outre à l'une et/ou à l'autre des dispositions suivantes :
- les moyens d'enregistrement sont prévus pour enregistrer la valeur maximale du courant de foudre, à chaque fois que la ligne de mise à la terre dissipe un coup de foudre ;
- les moyens d'enregistrement sont prévus pour enregistrer une succession de valeurs du courant de foudre en fonction du temps, à chaque fois que la ligne de mise à la terre dissipe un coup de foudre ;
- les moyens de mesure comportent :
   . un circuit magnétique qui est fermé sur lui-même et qui est destiné à être disposé autour de la ligne de mise à la terre pour que le courant de foudre parcourant la ligne de mise à la terre génère dans ce circuit magnétique un champ magnétique, ledit circuit magnétique comportant un noyau formé en un matériau magnétique solide qui présente au moins une interruption complète occupée par un matériau non magnétique,
   . et un circuit électrique comportant un enroulement disposé autour du circuit magnétique pour que le champ magnétique généré dans ce circuit magnétique traverse axialement ledit enroulement en engendrant dans cet enroulement un courant induit représentatif dudit courant de foudre,
   l'interruption du noyau magnétique permettant d'une part que le courant induit dans l'enroulement soit une fonction sensiblement linéaire du courant de foudre, malgré la très large plage de valeurs possibles du courant de foudre, et d'autre part que ce courant induit ne soit sensiblement pas influencé par le spectre en fréquence du courant de foudre ;
- la ou chaque interruption du noyau magnétique présente une longueur et le noyau magnétique comporte une section moyenne qui sont telles que la longueur de l'interruption, ou la somme des longueurs des différentes interruptions du noyau magnétique, est comprise entre 0,5 et 2 fois la racine carrée de la section du noyau magnétique ;
- l'interruption du noyau magnétique est constituée par un entrefer d'air ;
- l'interruption du noyau magnétique est constituée par un tronçon de matériau solide non magnétique qui est rapporté sur le noyau magnétique ;
- ledit tronçon de matériau non magnétique est amovible ;
- un condensateur est connecté en série avec l'enroulement pour filtrer les composantes de basse fréquence du courant induit dans cet enroulement ;
- les moyens de mesure délivrent un signal représentatif du courant de foudre, lesdits moyens de mesure étant connectés à un microprocesseur pour lui transmettre ledit signal, le microprocesseur étant connecté à une horloge, à une mémoire et à une interface, et ledit microprocesseur étant programmé pour stocker dans la mémoire les mesures du courant de foudre qui lui sont fournies par les moyens de mesure avec la date (par exemple : jour, mois, année, heure, minute, seconde) du courant de foudre correspondant, le microprocesseur étant également programmé pour restituer le contenu de la mémoire à l'interface ;
- l'interface est connectée à un transmetteur téléphonique par l'intermédiaire de moyens de transmission d'information à distance sans contact électrique ;
- le microprocesseur est programmé pour ne restituer le contenu de la mémoire à l'interface que s'il a préalablement reçu un signal codé déterminé.

L'invention a encore pour objet un équipement de protection contre la foudre doté d'un dispositif de surveillance tel que défini ci-dessus.

D'autres caractéristiques et avantages de l'invention apparaîtront au cours de la description détaillée suivante d'une de ses formes de réalisation, donnée à titre d'exemple non limitatif, en regard des dessins joints.

Sur les dessins :
- la figure 1 est une vue schématique d'un dispositif de surveillance selon l'invention, équipant la ligne de mise à la terre d'un paratonnerre ;
- la figure 2 est une vue en coupe selon la ligne II-II de la figure 1, et
- les figures 3 et 4 représentent très schématiquement des éclateurs ou parafoudres équipés de dispositifs de surveillance similaires à celui des figures 1 et 2.

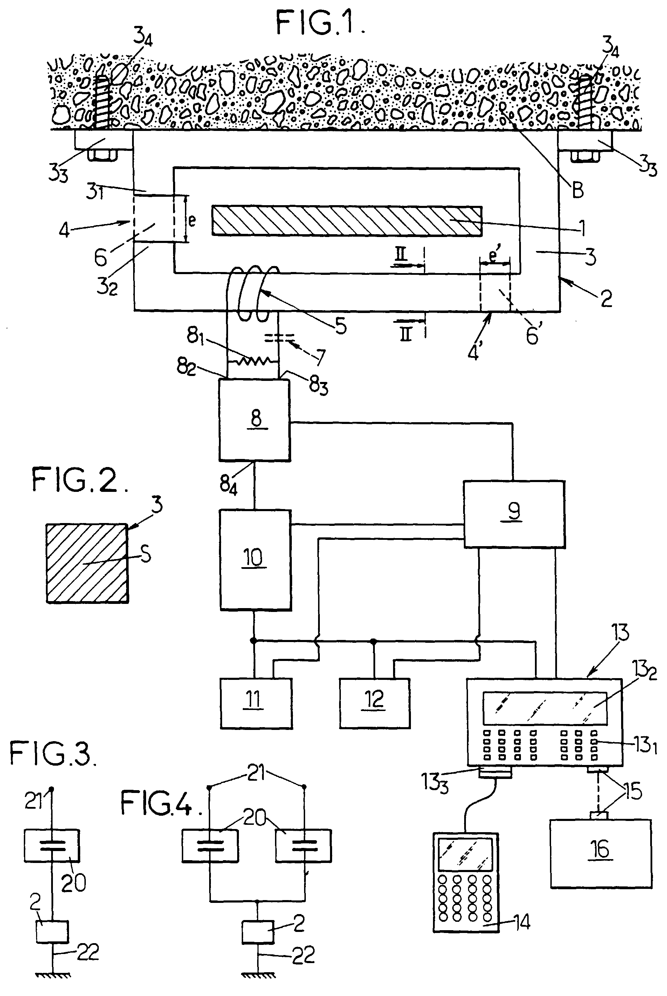

Sur la figure 1 est représenté un mur extérieur B d'un bâtiment, sur la hauteur duquel court une ligne de mise à la terre 1 conductrice, reliée d'une part à la pointe d'un paratonnerre (non représentée), et d'autre part à la terre. Généralement, cette ligne de mise à la terre se présente sous la forme d'un ruban de cuivre.

Au moins une partie de la ligne 1 de mise à la terre est maintenue écartée du mur B, par des supports (non représentés), de façon qu'un circuit magnétique 2 puisse être disposé de façon à se refermer sur lui-même autour de la ligne 1 de mise à la terre, sans être en contact électrique avec ladite ligne.

Dans l'exemple représenté sur la figure 1, le circuit magnétique 2 comporte un noyau 3 en matériau magnétique, par exemple en fer doux ou de préférence en ferrite, qui s'étend autour de la ligne 1 de mise à la terre sans toutefois se refermer sur lui-même, le noyau 3 présentant ainsi deux extrémités axiales 3₁, 3₂, qui sont séparées l'une de l'autre par un espace 4 d'entrefer rempli d'air qui complète le circuit magnétique. Ainsi, le circuit magnétique 2 est constitué d'une part par le noyau 3 et d'autre part par l'espace 4 occupé par un matériau non magnétique, ici de l'air.

Dans l'exemple particulier représenté, le noyau 3 a une forme de cadre sensiblement rectangulaire qui présente une section S également rectangulaire (figure 2) mesurant par exemple deux centimètres sur deux centimètres.

Un des côtés du cadre formé par le noyau 3 est adjacent au mur B et fixé à ce mur par des pattes 3₃ traversées par des vis 3₄ qui pénètrent dans le mur B. Toutefois, le noyau 3 pourrait avoir toute autre forme s'étendant autour de la ligne 1 de mise à la terre, avec au moins une interruption, et il pourrait être fixé au mur B par tout autre moyen.

En variante, l'espace 4 pourrait être occupé par un tronçon 6 de matériau solide non magnétique, par exemple du cuivre ou de l'aluminium.

Grâce à cet espace 4, le champ magnétique induit dans le circuit magnétique 2 par un courant de foudre parcourant la ligne de terre 1 est une fonction sensiblement linéaire de ce courant de foudre, et d'autre part la perméabilité globale du circuit magnétique est sensiblement indépendante du spectre en fréquence du courant de foudre, au contraire d'un noyau magnétique qui se refermerait sur lui-même.

De préférence, pour que l'efficacité du circuit magnétique 2 soit optimale, l'espace 4 aura une longueur e comprise entre 0,5.√S et 2.√S.

De plus, lorsque l'espace 4 est laissé libre, il présente l'avantage de faciliter la mise en place du circuit magnétique 2 sur une ligne de mise à la terre 1 déjà posée, en permettant le passage de ladite ligne de mise à la terre au travers du cadre formé par le circuit magnétique.

Dans ce même but, lorsque l'espace 4 est occupé par un tronçon 6 de matériau solide non magnétique, il est avantageux que ce tronçon soit amovible.

Eventuellement, le noyau magnétique 3 peut être interrompu en plusieurs endroits. Comme représenté sur la figure 1, il peut par exemple être interrompu non seulement par l'espace 4 susmentionné, mais en outre par un espace 4' supplémentaire occupé par un matériau solide non magnétique 6' qui est fixé au noyau 3 de part et d'autre de l'espace 4'.

Dans ce cas, de façon préférable, la somme des longueurs e + e' des espaces 4 et 4' doit encore être comprise entre 0,5.√S et 2.√S.

Un circuit électrique qui comporte un enroulement 5 présentant au moins une spire et jusqu'à quelques dizaines de spires, est bobiné autour du noyau magnétique 3 ou éventuellement autour de l'espace 4 ou de l'espace 4', notamment lorsque cet espace est occupé par un matériau solide non magnétique 6 ou 6'. De cette façon, un champ magnétique induit dans ce noyau magnétique par le passage d'un courant de foudre dans la ligne de mise à la terre 1, traverse axialement l'enroulement 5 et induit dans cet enroulement un courant représentatif du courant de foudre, qui est sensiblement une fonction linéaire de ce courant de foudre. On obtient ainsi une mesure du courant de foudre qui peut être précise à environ 10 % prés.

Le circuit comportant l'enroulement 5 est connecté entre deux bornes d'entrée 8₂, 8₃ d'un convertisseur analogique-numérique 8, une résistance 8₁ étant connectée en parallèle entre les deux entrées 8₂ et 8₃ pour délivrer entre ces entrées un signal de tension proportionnel au courant qui parcourt l'enroulement 5. Eventuellement, la résistance 8₁ pourrait être intégrée dans le convertisseur analogique-numérique 8.

Avantageusement, un condensateur 7 est connecté en série avec l'enroulement 5, de façon à filtrer les composantes de plus basse fréquence du courant qui parcourt l'enroulement 5.

Le convertisseur analogique-numérique 8 est alimenté par un circuit d'alimentation 9, qui peut être de tout type connu et qui pourrait éventuellement utiliser l'énergie de l'onde électromagnétique générée lors de la formation d'un éclair, comme enseigné par exemple dans le document FR-A-2 624 319.

Le convertisseur analogique-numérique 8 comporte également une borne de sortie 8₄ qui est connectée à un microprocesseur 10 pour délivrer à celui-ci un signal représentatif du courant de foudre.

Le microprocesseur 10 est également alimenté par le circuit d'alimentation 9, et il est connecté à une horloge 11, à une mémoire 12, et à un circuit d'interface 13, les trois circuits 11, 12, 13 étant eux-mêmes alimentés par l'alimentation 9.

Le microprocesseur 10 peut être programmé pour stocker dans la mémoire 12, à chaque fois que la foudre tombe sur le paratonnerre, la valeur maximale du courant de foudre ainsi que la date de ce courant de foudre (par exemple : jour, mois, année, heure, minute, seconde), cette date étant fournie par l'horloge 11.

Eventuellement, le microprocesseur 10 peut également être programmé pour stocker dans la mémoire 12, à chaque fois que la foudre tombe sur le paratonnerre, une succession de valeurs du courant de foudre en fonction du temps, c'est-à-dire la courbe du courant de foudre en fonction du temps, ainsi que la date du coup de foudre considéré.

Le circuit d'interface 13 peut éventuellement comporter un clavier 13₁ et un écran 13₂ pour interroger la mémoire 12 par l'intermédiaire du microprocesseur 10, de façon à contrôler l'intensité des courants de foudre qui ont parcouru la ligne de mise à la terre 1 à chaque fois que la foudre est tombée sur le paratonnerre, pendant une période donnée.

Eventuellement, le circuit d'interface 13 pourrait ne pas comporter de clavier et d'écran, mais simplement un connecteur 13₃ sur lequel peut se connecter un boîtier portatif 14, lui-même doté d'un clavier et d'un écran, pour contrôler les courants de foudre stockés dans la mémoire 12. Le circuit d'interface 13 peut également comporter le connecteur 13₃ en plus d'un clavier et d'un écran.

Il serait également possible de raccorder une imprimante au circuit d'interface 13, de façon à faire imprimer les valeurs mesurées des courants de foudre et leurs dates, ou bien les courbes des courants de foudre et leurs dates.

Eventuellement, comme représenté sur la figure 1, le circuit d'interface 13 peut aussi être connecté à un transmetteur téléphonique 16, par l'intermédiaire de coupleurs optiques ou éventuellement acoustiques 15 (sans contact électrique entre les circuits 13 et 16), de façon à pouvoir interroger à distance le contenu de la mémoire 12 par l'intermédiaire du microprocesseur 10.

De préférence, le microprocesseur est programmé pour ne restituer le contenu de la mémoire 12 à l'interface 13 que s'il a préalablement reçu un signal codé déterminé, de façon à préserver la confidentialité des données contenues dans la mémoire 12.

Comme représenté sur les figures 3 et 4, un dispositif similaire à celui des figures 1 et 2 peut être employé pour surveiller un ou plusieurs éclateurs ou parafoudres 20 protégeant des lignes électriques 21 basse tension, moyenne tension ou haute tension, en mesurant le courant de foudre qui parcourt la ligne de mise à la terre 22 de ces éclateurs ou parafoudres au moyen d'un circuit magnétique 2 similaire à celui décrit ci-dessus.

Lorsque plusieurs éclateurs ou parafoudres 20 doivent être surveillés, il est possible de prévoir une ligne de mise à la terre 22 et un dispositif de surveillance pour chacun d'eux (figure 3), ou bien de prévoir une ligne 22 de mise à la terre commune à plusieurs éclateurs ou parafoudres, et un dispositif de surveillance également commun équipant cette ligne de mise à la terre (figure 4).

## Revendications

1. Procédé de surveillance d'un équipement de protection contre la foudre présentant une ligne de mise à la terre (1) qui est destinée à dissiper les coups de foudre et qui est parcourue alors par un courant électrique, dit courant de foudre, ce courant de foudre présentant une certaine intensité et un certain spectre en fréquence, procédé dans lequel on effectue une mesure de l'intensité du courant de foudre, cette mesure étant une fonction sensiblement linéaire du courant de foudre, et
on effectue cette mesure à chaque fois que la ligne de mise à la terre dissipe un coup de foudre,
**caractérisé en ce qu'**on enregistre au moins une valeur du courant de foudre et une date de ce courant de foudre à chaque fois que la ligne de mise à la terre dissipe un coup de foudre.

2. Dispositif de surveillance d'un équipement de protection contre la foudre comportant une ligne de mise à la terre qui est destinée à dissiper des coups de foudre et qui est parcourue alors par un courant électrique, dit courant de foudre, ce courant de foudre présentant une certaine intensité et un certain spectre en fréquence, le dispositif comportant des moyens de mesure (2, 5, 8₁, 8) pour effectuer une mesure de l'intensité du courant de foudre, cette mesure étant une fonction sensiblement linéaire du courant de foudre,
les moyens de mesure sont adaptés pour mesurer l'intensité du courant de foudre à chaque fois que la ligne de mise à la terre dissipe un coup de foudre,
**caractérisé en ce qu'**il comporte en outre des moyens d'enregistrement (10, 11, 12) pour enregistrer au moins une valeur du courant de foudre et une date de ce courant de foudre à chaque fois que la ligne de mise à la terre dissipe un coup de foudre.

3. Dispositif selon la revendication 2, dans lequel les moyens d'enregistrement (10, 11, 12) sont prévus pour enregistrer la valeur maximale du courant de foudre, à chaque fois que la ligne de mise à la terre dissipe un coup de foudre.

4. Dispositif selon l'une quelconque des revendications 2 et 3, dans lequel les moyens d'enregistrement (10, 11, 12) sont prévus pour enregistrer une succession de valeurs du courant de foudre en fonction du temps, à chaque fois que la ligne de mise à la terre dissipe un coup de foudre.

5. Dispositif selon l'une quelconque des revendications 2 à 4, dans lequel les moyens de mesure comportent :
- un circuit magnétique (2) qui est fermé sur lui-même et qui est destiné à être disposé autour de la ligne (1) de mise à la terre pour que le courant de foudre parcourant la ligne de mise à la terre génère dans ce circuit magnétique un champ magnétique, ledit circuit magnétique (2) comportant un noyau (3) formé en un matériau magnétique solide qui présente au moins une interruption complète (4, 4') occupée par un matériau non magnétique,
- et un circuit électrique comportant un enroulement (5) disposé autour du circuit magnétique (2) pour que le champ magnétique généré dans ce circuit magnétique traverse axialement ledit enroulement en engendrant dans cet enroulement un courant induit représentatif dudit courant de foudre.

6. Dispositif selon la revendication 5, dans lequel la ou chaque interruption du noyau magnétique (3) présente une longueur (e, e') et le noyau magnétique comporte une section moyenne (S) qui sont telles que la longueur (e) de l'interruption, ou la somme (e + e') des longueurs des différentes interruptions du noyau magnétique, est comprise entre 0,5 et 2 fois la racine carrée (√S) de la section du noyau magnétique.

7. Dispositif selon l'une quelconque des revendications 5 et 6, dans lequel l'interruption (4) du noyau magnétique est constituée par un entrefer d'air.

8. Dispositif selon l'une quelconque des revendications 5 et 6, dans lequel l'interruption (4, 4') du noyau magnétique est constituée par un tronçon (6, 6') de matériau solide non magnétique qui est rapporté sur le noyau magnétique (3).

9. Dispositif selon la revendication 8, dans lequel ledit tronçon de matériau non magnétique est amovible.

10. Dispositif selon l'une quelconque des revendications 5 à 9, dans lequel un condensateur (7) est connecté en série avec l'enroulement (5) pour filtrer les composantes de basse fréquence du courant induit dans cet enroulement.

11. Dispositif selon l'une quelconque des revendications 2 à 10, dans lequel les moyens de mesure (2, 5, 8₁, 8) délivrent un signal représentatif du courant de foudre, lesdits moyens de mesure étant connectés à un microprocesseur (10) pour lui transmettre ledit signal, le microprocesseur étant connecté à une horloge (11), à une mémoire (12) et a une interface (13), et ledit microprocesseur étant programmé pour stocker dans la mémoire (12) les mesures du courant de foudre qui lui sont fournies par les moyens de mesure avec la date du courant de foudre correspondant, le microprocesseur (10) étant également programmé pour restituer le contenu de la mémoire (12) au circuit d'interface (13).

12. Dispositif selon la revendication 11, dans lequel l'interface (13) est connecté à un transmetteur téléphonique (16) par l'intermédiaire de moyens de transmission d'information à distance sans contact électrique.

13. Dispositif selon l'une quelconque des revendications 11 et 12 dans lequel le microprocesseur (10) est programmé pour ne restituer le contenu de la mémoire (12) à l'interface (13) que s'il a préalablement reçu un signal codé déterminé.

14. Equipement de protection contre la foudre doté d'un dispositif de surveillance selon l'une quelconque des revendications 2 à 13.

## Patentansprüche

1. Verfahren zur Überwachung einer Blitzschutzanlage mit einer Erdschlußleitung (1), die dazu bestimmt ist, Blitzschläge abzuführen und die dabei von einem elektrischen Strom, einem sogenannten Blitzstrom, durchflossen wird, wobei der Blitzstrom eine bestimmte Intensität und ein bestimmtes Frequenzspektrum aufweist, ein Verfahren, in welchem eine Messung der Intensität des Blitzstromes ausgeführt wird, wobei diese Messung eine im wesentlichen lineare Abhängigkeit vom Blitzstrom hat und diese Messung jedesmal ausgeführt wird, wenn die Erdschlußleitung einen Blitzschlag abführt,
**dadurch gekennzeichnet**, daß wenigstens ein Wert des Blitzstromes und ein Datum des Blitzstromes aufgezeichnet wird, wenn die Erdschlußleitung einen Blitzschlag abführt.

2. Vorrichtung zur Überwachung einer Blitzschutzanlage mit einer Erdschlußleitung, die dazu bestimmt ist, Blitzschläge abzuführen und die dabei von einem elektrischen Strom durchflossen wird, dem sogenannten Blitzstrom, wobei der Blitzstrom eine bestimmte Intensität und ein bestimmtes Frequenzspektrum aufweist, wobei die Vorrichtung eine Meßeinrichtung (2, 5, 8₁, 8) umfaßt, um eine Messung der Intensität des Blitzstromes auszuführen, wobei diese Messung eine im wesentlichen lineare Abhängigkeit vom Blitzstrom hat, wobei die Meßeinrichtung derart ausgebildet ist, daß sie die Intensität des Blitzstromes jedesmal mißt, wenn die Erdschlußleitung einen Blitzschlag abführt,
**dadurch gekennzeichnet,** daß sie ferner Aufzeichnungsmittel (10, 11, 12) zum Aufzeichnen wenigstens eines Wertes des Blitzstromes und eines Datums des Blitzstromes, jedesmal, wenn die Erdschlußleitung einen Blitzschlag abführt, umfaßt.

3. Vorrichtung nach Anspruch 2, in welcher die Aufzeichnungsmittel (10, 11, 12) vorgesehen sind, um den maximalen Wert des Blitzstromes aufzuzeichnen, jedesmal, wenn die Erdschlußleitung einen Blitzschlag abführt.

4. Vorrichtung nach einem der Ansprüche 2 und 3, in welcher die Aufzeichnungsmittel (10, 11, 12) vorgesehen sind, um eine Folge von Werten des Blitzstromes in Abhängigkeit von der Zeit aufzuzeichnen, jedesmal, wenn die Erdschlußleitung einen Blitzschlag abführt.

5. Vorrichtung nach einem der Ansprüche 2 bis 4, in welcher die Meßeinrichtung umfaßt:
- einen Magnetkreis (2), der in sich geschlossen ist und der dazu bestimmt ist, um die Erdschlußleitung (1) herum angeordnet zu sein, so daß der die Erdschlußleitung durchfließende Blitzstrom in dem Magnetkreis ein magnetisches Feld erzeugt, wobei der Magnetkreis (2) einen Kern (3) aus einem festen magnetischen Material umfaßt, der wenigstens eine vollständige Unterbrechung (4, 4') aufweist, die von einem nicht-magnetischen Material eingenommen ist,
- und einen elektrischen Schaltkreis mit einer Spule (5), die um den Magnetkreis (2) herum angeordnet ist, so daß das in dem Magnetkreis erzeugte magnetische Feld die Spule axial durchquert und dabei in dieser Spule einen für den Blitzstrom repräsentativen, induzierten Strom erzeugt.

6. Vorrichtung nach Anspruch 5, in welcher die bzw. jede Unterbrechung des magnetischen Kerns (3) eine Länge (e, e') aufweist und der magnetische Kern einen mittleren Querschnitt (S) umfaßt, die derart gewählt sind, daß die Länge (e) der Unterbrechung, bzw. die Summe (e + e') der Längen verschiedener Unterbrechungen des magnetischen Kerns, zwischen dem 0,5- und 2-fachen der Quadratwurzel (√S) des Querschnitts des Magnetkerns beträgt.

7. Vorrichtung nach einem der Ansprüche 5 und 6, in welcher die Unterbrechung (4) des Magnetkerns durch einen Luftspalt gebildet ist.

8. Vorrichtung nach einem der Ansprüche 5 und 6, in welcher die Unterbrechung (4, 4') des Magnetkerns durch ein Teilstück (6, 6') aus festem, nicht-magnetischen Material gebildet ist, das auf dem magnetischen Kern (3) aufgesetzt ist.

9. Vorrichtung nach Anspruch 8, in welcher das Teilstück aus nicht-magnetischem Material lösbar ist.

10. Vorrichtung nach einem der Ansprüche 5 bis 9, in welcher ein Kondensator (7) mit der Spule (5) in Reihe verbunden ist, um die niederfrequenten Bestandteile des induzierten Stroms in der Spule zu filtern.

11. Vorrichtung nach einem der Ansprüche 2 bis 10, in welcher die Meßeinrichtung (2, 5, 8₁ 8) ein repräsentatives Signal des Blitzstromes liefert, wobei die Meßeinrichtung mit einem Mikroprozessor (10) verbunden ist, um diesem das Signal zu übermitteln, wobei der Mikroprozessor an eine Uhr (11), an einen Speicher (12) und an eine Schnittstelle (13) angeschlossen ist und wobei der Mikroprozessor derart programmiert ist, daß dieser in dem Speicher (12) die Messungen des Blitzstromes speichert, die diesem von der Meßeinrichtung mit dem Datum des entsprechenden Blitzstromes geliefert werden, wobei der Mikroprozessor (10) auch derart programmiert ist, daß dieser den Inhalt des Speichers (12) an der Schnittstellenschaltung (13) wiedergibt.

12. Vorrichtung nach Anspruch 11, in welcher die Schnittstelle (13) mit einer Fernsprecheinrichtung (16) mittels elektrokontaktfreien, auf Abstand wirkenden Informationsübertragungsmitteln verbunden ist.

13. Vorrichtung nach einem der Ansprüche 11 und 12, in welcher der Mikroprozessor (10) derart programmiert ist, daß dieser den Inhalt des Speichers (12) an der Schnittstelle (13) nur dann wiedergibt, wenn dieser vorher ein vorbestimmtes Codesignal empfangen hat.

14. Anlage zum Schutz gegen Blitzschlag, die mit einer Überwachungsvorrichtung gemäß einem der Ansprüche 2 bis 13 versehen ist.

## Claims

1. A method of monitoring anti-lightning protection equipment that includes a grounding line (1), which is designed to dissipate lightning strikes and which is then traversed by an electrical current, called lightning current, this lightning current having a certain intensity and a certain frequency spectrum, method in which the intensity of the lightning current is measured, this measure being a substantially linear fonction of the lightning current, and this measure is carried out on each occasion that the grounding line dissipates a lightning strike, characterized in that at least one value of the lightning current is recorded together with the date of said lightning current on each occasion that the grounding line dissipates a lightning strike.

2. Apparatus for monitoring anti-lightning protection equipment that includes a grounding line, which is designed to dissipate the lightning strikes and which is then traversed by an electrical current, called lightning current, this lightning current having a certain intensity and a certain frequency spectrum, the apparatus including means (2, 5, 8₁,8), for measuring the intensity of the lightning current, this measure being a substantially linear function of the lightning current, the measuring means are designed to measure the intensity of the lightning strike on each occasion that the grounding line dissipates a lightning strike, characterized in that it further includes recording means (10, 11, 12) for recording at least one lightning current value and a date of said lightning current on each occasion that the grounding lightning current on each occasion that the grounding line dissipates a lightning strike.

3. Apparatus according to claim 2, in which the recording means (10, 11, 12) are designed to record the maximum value of the lightning current on each occasion that the grounding line dissipates a lightning strike.

4. Apparatus according to claim 2 or 3, in which the recording means (10, 11, 12) are designed to record a succession of values of the lightning current as a function of time, on each occasion that the grounding line dissipates a lightning strike.

5. Apparatus according to any one of claims 2 to 4, in which the measurement means include :
a magnetic circuit (2) which forms a closed loop and which is designed to be disposed around the grounding line (1) so that the lightning current travelling along the grounding line generates a magnetic field in said magnetic circuit, said magnetic circuit (2) including a core (3) made of a solid magnetic material that includes at least one complete gap (4, 4') occupied by a non-magnetic material ; and
an electrical circuit including a winding (5) disposed around the magnetic circuit (2) so that the magnetic field generated in said magnetic circuit passes axially along said winding, thereby generating an induced current in said winding representative of the lightning current.

6. Apparatus according to claim 5, in which the, or each, gap in the magnetic core (3) has a width (e, e'), and the magnetic core has a mean section (S) such that the total width (e, or e + e') of the gap or gaps in the magnetic core lies in the range half to twice the square root (√S) of the section of the magnetic core.

7. Apparatus according to claim 5 or 6, in which the gap (4) in the magnetic core is constituted by an air gap.

8. Apparatus according to claim 5 or 6, in which the gap (4, 4') in the magnetic core is constituted by a length (6, 6') of non-magnetic solid material which is fitted to the magnetic core (3).

9. Apparatus according to claim 8, in which said length of non-magnetic material is removable.

10. Apparatus according to any one of claims 5 to 9, in which a capacitor (7) is connected in series with the winding (5) to block low frequency components of the current induced in said winding.

11. Apparatus according to any one of claims 2 to 10, in which the measurement means (2, 5, 81, 8) deliver a signal representative of the lightning current, said measurement means being connected to a microprocessor (10) to transmit said signal thereto, the microprocessor being connected to a clock (11), a memory (12), and an interface (13), and said microprocessor being programmed to store in the memory (12) the lightning current measurements that are supplied thereto by the measurement means together with the corresponding date of the lightning current, the microprocessor (10) also being programmed to play back the contents of the memory (12) to the interface circuit (13).

12. Apparatus according to claim 11, in which the interface (13) is connected to a telephone interface (16) via means for remote transmission of information without making electrical contact.

13. Apparatus according to claim 11 or 12, in which the microprocessor (10) is programmed to play back the contents of the memory (12) to the interface (13) only after it has previously received a determined code signal.

14. Equipment for providing anti-lightning protection, and provided with monitoring apparatus according to any one of claims 2 to 13.
